# DEMANDE DE BREVET EUROPEEN

(11) **EP 1 571 705 A2**
(43) Date de publication de la demande: **07.09.2005**
(21) Numéro de dépôt: 05290392.9
(22) Date de dépôt: 22.02.2005
(51) Int. Cl.: H01L 21/762

(54) **Réalisation d'une entité en matériau semiconducteur sur substrat**

(30) Priorité: 01.03.2004 FR 0402080; 07.06.2004 US 863193
(71) Demandeur: S.O.I.Tec Silicon on Insulator Technologies, 38190 Bernin (FR)
(72) Inventeur: Le Vaillant, Yves Mathieu, 38920 Crolles (FR); Rayssac, Olivier, 38100 Grenoble (FR); Fernandez, Christophe, 38000 Grenoble (FR)
(74) Mandataire: Le Forestier, Eric

(57) **Abrégé**

L'invention concerne une réalisation d'une entité en matériau choisi parmi les matériaux semiconducteurs sur substrat.

Le procédé est mis en oeuvre à partir d'un substrat donneur et d'un substrat récepteur, le substrat récepteur comprenant en surface un ou plusieurs motifs en relief, le substrat donneur étant collé au substrat récepteur au niveau de ce ou ces motifs.

Une zone fragile est en outre présente dans le substrat donneur à une profondeur déterminée sous au moins un motif de sorte à définir une couche mince entre la zone fragile et l'interface de collage.

Le procédé comprend un apport d'énergie de sorte à :
― conserver le collage entre chaque motif et le substrat donneur ;
― détacher du substrat donneur une partie de la couche mince située au niveau de chaque motif, en rompant des liaisons dans la zone fragile et dans l'épaisseur de la couche mince, cette partie détachée formant l'entité.

L'invention comprend en outre une plaquette et une application du procédé à la réalisation de puces pour l'électronique, l'optique ou l'optoélectronique.

## Description

La présente invention concerne la réalisation d'une entité en matériau semiconducteur sur un substrat.

Cette entité semiconductrice a communément une forme géométrique parallélépipédique ou cylindrique.

Dans la majeure partie des applications connues, de telles entités sur substrat sont comprises, telles quelles ou après traitements, au moins en partie dans des puces destinées à l'électronique, telles que des composants MEMs (acronyme anglo-saxon de « Microelectromechanical System »), ou à l'optique et à l'optoélectronique, telles que des émetteurs LEDs (acronyme anglo-saxon de « Light Emitting Diodes ») ou LDs (acronyme anglo-saxon de « Laser Diodes »), ou des récepteurs optiques.

Ces entités ou puces sont habituellement réalisées sur un substrat par plusieurs centaines ou par plusieurs milliers d'unités, arrangées habituellement dans une matrice régulière.

Après la réalisation des puces, une individualisation et un transfert de ces puces sur des substrats dits « récepteurs » sont alors nécessaires à mettre en oeuvre.

L'opération d'individualisation des puces est souvent délicate car elle doit être mise en oeuvre de façon particulièrement précise et propre, notamment pour des puces destinées à certaines applications telles que des applications pour des lasers.

En effet, dans le domaine des lasers à semiconducteur, la lumière est émise au niveau des miroirs, les miroirs étant des facettes transversales des puces, le long desquelles auront lieu des opérations d'individualisation.

L'individualisation des puces doit donc être faite de façon propre, sans détérioration de la qualité des facettes, en conservant leur planéité.

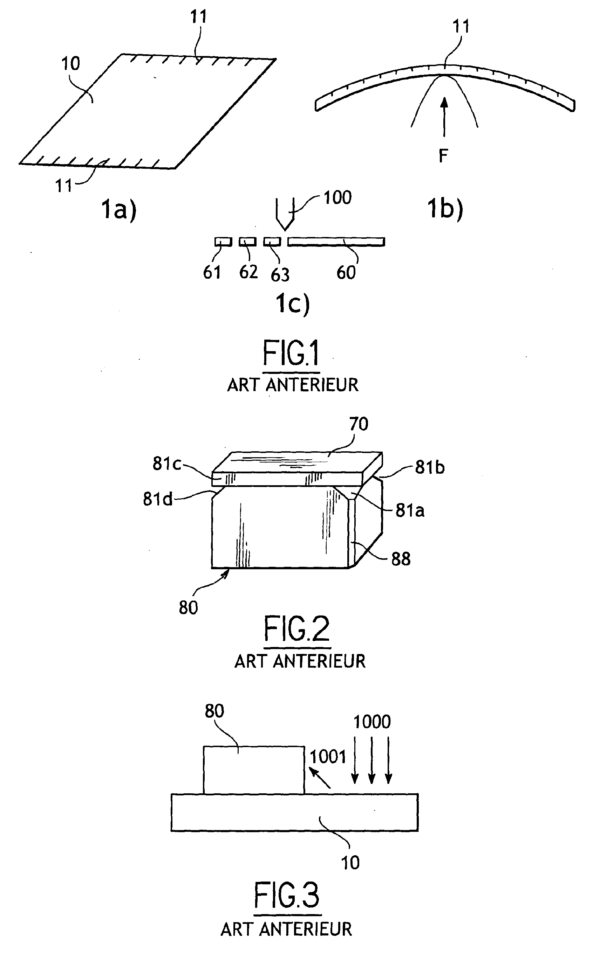

Plusieurs techniques connues d'individualisation des puces peuvent être mises en oeuvre :
En référence à la figure 1, une première technique connue d'individualisation, par clivage mécanique entre les puces, est proposée.
En référence à la figure 1a, sur le substrat 10 comprenant sur sa face avant les puces (non représentées), des amorces de clivage, telle que l'amorce 11, sont réalisées dans des directions cristallographiques appropriées, par une pointe dure (telle qu'une pointe en diamant).
En référence à la figure 1b, une contrainte mécanique F exercée sur la face arrière du substrat 10 au niveau de l'amorce de clivage 11 et dans la direction d'un plan cristallographique approprié, permet de cliver le substrat 10 le long de l'amorce 11. Sont créées ainsi une pluralité de barrettes comprenant chacune une pluralité de puces.
En référence à la figure 1c, chaque barrette 60 est alors fractionnée, au moyen d'une pointe en diamant, en plusieurs plots 61, 62, 63,..., chacun comprenant au moins une puce, l'individualisation des puces étant ainsi obtenue.

Cependant, cette première technique a un rendement assez faible sur des grandes séries de puces.

Cette première technique présente en outre des risques de création de défauts mécaniques dans les puces, lors des opérations d'application de contrainte.

En référence à la figure 2, une deuxième technique connue d'individualisation, par clivage chimique entre les puces, est proposée.

Un masque 70 couvre chacune des puces 80, et protège d'une attaque chimique la puce 80, par exemple par simple gravure sèche ou après illumination électromagnétique au cours d'une photolithographie, et grave le substrat environnant en formant des sillons entre les puces. La découpe finale se fait alors par des moyens conventionnels.

Cette deuxième technique semble être plus adaptée que la première technique à une fabrication de puces en grandes séries, du fait de la possibilité d'individualiser les puces instantanément sur toute la surface du substrat.

Cependant, cette deuxième technique provoque, malgré la protection conférée par le masque 80, des sous-gravures 81a, 81b, 81c, 81d dans la puce 80 sous le masque 70 et des gravures parasites 82 aux angles de la puce 80.

Et la puce 80 va ainsi perdre de sa qualité, et notamment des propriétés de planéité de ses facettes.

En référence à la figure 3, une troisième technique connue d'individualisation est proposée.

Elle comprend l'utilisation d'une RIE (acronyme anglo-saxon de « Reactive Ion Etching ») qui consiste à graver le substrat 10 entre les puces 80 de façon isotropique en bombardant la surface du substrat 10 d'ions 1000 dont la nature et l'énergie sont adaptées pour graver le substrat 10, et permet ainsi d'individualiser les puces 80.

Cependant, cette troisième technique est souvent coûteuse et délicate à mettre en oeuvre.

De plus, des problèmes de rétro-diffusion d'ions 1001 peuvent survenir, gravant des facettes de la puce 80, la rendant notamment moins plane.

La présente invention selon un premier aspect tend à améliorer la situation en proposant un procédé de réalisation d'une entité en matériau choisi parmi les matériaux semi-conducteurs, sur un substrat récepteur, caractérisé en ce qu'il est mis en oeuvre à partir d'un substrat donneur et du substrat récepteur, le substrat récepteur comprenant en surface un ou plusieurs motifs en relief, le substrat donneur étant collé au substrat récepteur au niveau de ce ou ces motifs, une zone fragile étant présente dans le substrat donneur à une profondeur déterminée de sorte à définir une couche mince entre la zone fragile et l'interface de collage, et en ce que le procédé comprend un apport d'énergie de sorte à :
- conserver le collage entre le motif et le substrat donneur ;
- détacher du substrat donneur une partie de la couche mince située au niveau de chaque motif, en rompant des liaisons dans la zone fragile et dans l'épaisseur de la couche mince, cette partie détachée formant l'entité.

Des aspects préférés du procédé de réalisation d'une entité sont :
- la rupture dans l'épaisseur de la couche mince est un clivage selon un ou des plans de glissement,
- l'apport d'énergie comprend un apport d'énergie localisé,
- l'apport d'énergie comprend un apport d'énergie localisé au niveau de la zone fragile,
- les forces de liaison au niveau de la zone fragile sont sensiblement moins importantes que les forces de collage entre le motif et le substrat récepteur,
- l'apport d'énergie comprend un apport d'énergie sensiblement homogène sur tout le volume de la plaquette constituée du substrat donneur et du substrat récepteur collés ensemble,
- il comprend en outre, avant l'apport d'énergie, une étape de fragilisation du substrat donneur de sorte à former la zone fragile,
- l'étape de fragilisation comprend :
   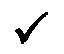 une implantation d'espèces atomiques dans le substrat donneur à une profondeur voisine de la profondeur de la zone fragile ;
   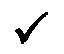 une surfragilisation de la zone implantée pour former la zone fragile.
- l'étape de fragilisation comprend une porosification d'une plaquette support pour former une couche poreuse en surface de cette plaquette support, suivie d'une croissance cristalline d'une couche supérieure sur la couche poreuse, lesdites plaquette support, couche poreuse et couche supérieure réalisant ledit substrat donneur, la couche poreuse réalisant ladite zone fragile,
- l'étape de fragilisation comprend un collage de deux plaquettes dont au moins une a sa surface de collage ayant été préalablement rugosifiée, suivie d'une réduction d'une des deux plaquettes collées de sorte à laisser une couche supérieure collée aux rugosités, la plaquette restante et la couche supérieure réalisant ledit substrat donneur, les rugosités réalisant ladite zone fragile,
- il comprend en outre, avant l'apport d'énergie, la formation d'une topographie du ou des motifs en surface du substrat récepteur,
- il comprend en outre, après l'apport d'énergie, une individualisation d'une ou de plusieurs entités en surface du substrat récepteur,
- il comprend en outre, après l'apport d'énergie, une liaison optique entre des entités,
- au moins une entité réalisée est en alliage III-V, et
- au moins un motif est en alliage III-V.

Selon un deuxième aspect, l'invention propose une plaquette obtenue au cours de la mise en oeuvre dudit procédé de réalisation, caractérisée en ce qu'elle est constituée de deux substrats collés ensemble, un des deux substrats comprenant :
- en surface des motifs saillants collés à l'autre substrat ; et
- une zone mécaniquement fragile située sous les motifs saillants..

Selon un troisième aspect, l'invention propose une application dudit procédé de réalisation, à la fabrication de puces sur substrat pour l'électronique, l'optique ou l'optoélectronique, une puce étant constituée d'un motif et de l'entité détachée sus-jacente, le substrat étant le substrat récepteur.

Une caractéristique de l'application est l'application selon l'application précédente plus précisément à la fabrication de puces pour lasers semi-conducteurs, tels que des émetteurs LEDs ou des LDs ou des récepteurs optiques.

D'autres aspects, buts et avantages de l'invention sont décrits dans la suite de ce document en illustration des figures suivantes :
La figure 1 représente un premier procédé de réalisation d'une entité en matériau semiconducteur sur un substrat selon l'état de la technique.
La figure 2 représente un deuxième procédé de réalisation d'une entité en matériau semiconducteur sur un substrat selon l'état de la technique.
La figure 3 représente un troisième procédé de réalisation d'une entité en matériau semiconducteur sur un substrat selon l'état de la technique.
La figure 4 représente une première technique de réalisation d'une zone fragile dans un substrat donneur.
Les figures 5a à 5d représentent les étapes principales d'une deuxième technique de réalisation d'une zone fragile dans un substrat donneur, la figure 5b représentant une étape alternative aux étapes successives représentées respectivement par les figures 5c et 5d.
La figure 6 représente un substrat donneur selon l'invention.
La figure 7 représente un collage du substrat donneur avec un substrat récepteur selon l'invention.
La figure 8 représente une étape de détachement de l'entité semiconductrice selon l'invention.
La figure 9 représente un exemple d'application du procédé selon l'invention.

Un premier but de l'invention est de réaliser une individualisation d'une entité en matériau choisi parmi les matériaux semiconducteurs (telle qu'une puce destinée à l'électronique, l'optique ou l'optoélectronique) à partir d'un réseau d'entités comprises dans un substrat donneur.

Un deuxième but de l'invention est de réaliser un prélèvement d'au moins une entité dans le substrat donneur, afin de la transférer sur un substrat récepteur.

Un troisième but de l'invention est de trouver une technique de réalisation d'une entité permettant d'obtenir, de façon optimum, sur le substrat récepteur une entité présentant des facettes particulièrement planes.

Un quatrième but de l'invention est de trouver une technique de réalisation d'une entité permettant d'obtenir, de façon optimum, sur le substrat récepteur une entité présentant une bonne qualité structurelle.

Un cinquième but de l'invention est de trouver une technique de réalisation d'une entité permettant d'obtenir, de façon optimum, sur le substrat récepteur une entité ayant des facettes sensiblement perpendiculaires au substrat récepteur.

Un sixième but de l'invention est de trouver une technique de transfert d'une pluralité d'entités de sorte à obtenir un substrat récepteur supportant un réseau choisi d'entités.

Un septième but de l'invention est de réaliser une matrice d'entités sur le substrat récepteur.

Un procédé selon l'invention comprend les étapes principales suivantes :
(a) formation d'une zone fragile dans un substrat donneur ;
(b) formation de motifs en surface d'un substrat récepteur ;
(c) collage du substrat récepteur sur le substrat donneur au niveau des motifs ;
(d) détachement d'une partie du substrat donneur collée au substrat récepteur au voisinage de la zone fragile.

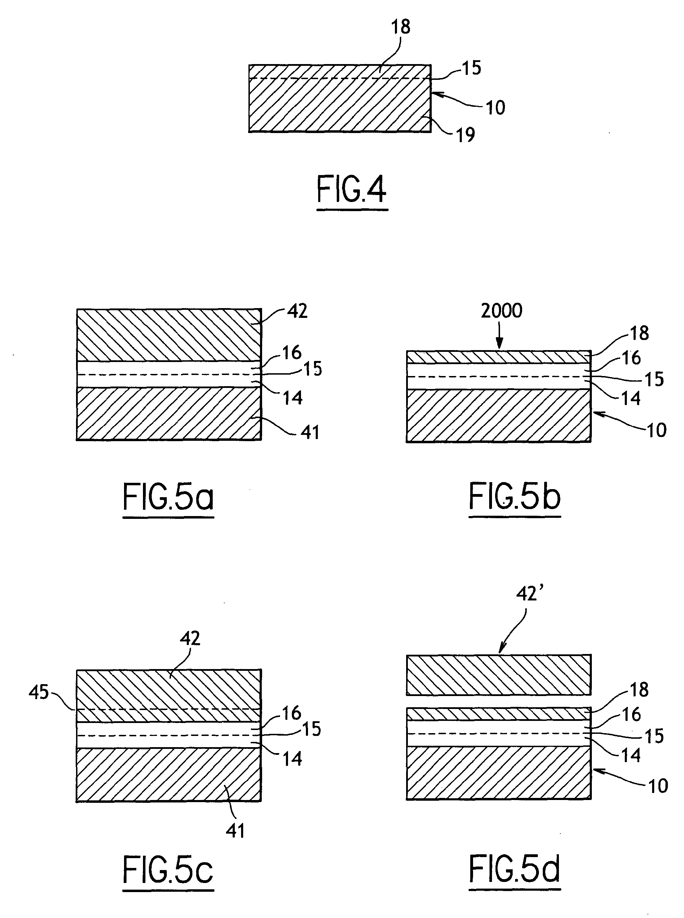

En référence aux figures 4 et 5a à 5d sont présentées des techniques de fragilisation, mettant en oeuvre l'étape (a), d'une couche permettant ainsi la formation d'une zone fragile 15 dans un substrat donneur 10.

Une zone fragile 15 est une zone qui présente à son niveau des faiblesses de liaison entre la partie qui lui est sus-jacente et la partie qui lui est sous-jacente, ces liaisons étant donc susceptibles d'être brisées avant le reste du substrat donneur 10 lors d'un apport d'énergie, tel un apport d'énergie mécanique.

En référence à la figure 4, est représenté un substrat donneur 10 comprenant une telle zone fragile 15, la partie du substrat donneur 10 supérieure à la zone fragile 15 est une couche référencée ici 18 et la partie du substrat donneur 10 inférieure à la zone fragile 15 est référencée 19.

La zone fragile 15 est formée de sorte que la couche 18 soit une couche mince dont l'épaisseur est comprise entre quelques nanomètres et un micron, notamment dans le cas où la zone fragile 15 comprend dans sa formation une étape d'implantation d'espèces atomiques (comme expliqué ci-après).

Une première technique de fragilisation comprend une implantation d'espèces atomiques (telles que de l'hydrogène et/ou de l'hélium) suivie d'une surfragilisation par traitement thermique, tel que notamment décrit dans le document FR 2 809 867.

La fragilisation au niveau de la zone 15 dépend principalement du budget thermique (identifiant un couple température/temps) utilisé, celui-ci déterminant le taux de fragilisation obtenu au final, ou en d'autres termes la perte d'énergie de liaison liée à cette fragilisation.

La diminution de l'énergie de liaison est pour cette première technique liée en particulier à l'énergie thermique qu'on apporte au niveau de la zone implantée 15 et qui pourra avoir comme conséquence de libérer des gaz d'implant qui y sont emprisonnés et de créer ainsi des emplacements sous pressurisés au niveau de la zone fragilisée 20 qui sont à l'origine de la fragilisation.

Par exemple, en implantant à 200 KeV d'hydrogène à une dose de 4,5.10¹⁶ cm⁻² dans une plaquette de silicium, et en faisant subir à la plaquette une surfragilisation à 500°C pendant 12 heures, on réussit à fragiliser de façon contrôlée au niveau de la zone 15.

Une deuxième technique de fragilisation, comprend la formation d'une interface fragile par création d'au moins une couche poreuse, comme décrit par exemple dans le document EP-A-0 849 788.

La zone fragile 15 (c'est à dire ici la couche poreuse) est formée sur la partie inférieure 19 du substrat donneur 10 et est suivie préférentiellement d'une croissance cristalline, telle qu'une épitaxie par CVD ou MBE (acronymes anglo-saxon respectifs de « Chemical Vapor Deposition » et de « Molecular Beam Epitaxy »), de la couche 18 sur la couche poreuse 15.

En référence aux figures 5a à 5d, est présentée une troisième technique de fragilisation pour former la zone fragile 15, qui comprend :
- une rugosification de la surface d'un premier substrat 41 et éventuellement de la rugosification d'un deuxième substrat 42 ;
- un collage du premier substrat 41 et du deuxième substrat 42 ;
- une réduction du deuxième substrat 42.

Ce procédé est notamment décrit dans le document FR 2 823 599.

Pour mettre en oeuvre l'étape de rugosification de surface, on utilise préférentiellement une gravure chimique dont le budget chimique (identifiant le tiercé dosage des espèces chimiques/temps/température) choisi déterminera la fragilisation obtenue au final ou, ce qui revient au même, la perte d'énergie de collage au niveau de la zone fragile 15.

La perte d'énergie de liaison (ou de collage) au niveau de la zone fragile 15 est ici liée à la rugosification de surface qui diminue les liaisons de contact entre le premier substrat 41 et le deuxième substrat 42 une fois que ceux-ci seront collés.

En jouant sur la rugosification, on peut ainsi contrôler l'énergie de liaison (ou de collage) entre lesdits deux substrats 41 et 42 collés.

Optionnellement, une première couche de collage 14 et une deuxième couche de collage 16 sont formées respectivement en surface du premier substrat 41 et en surface du deuxième substrat 42.

Une couche de collage peut par exemple être en SiO₂, formée par dépôt d'espèces atomiques de SiO₂ ou par oxydation thermique dans le cas où la surface à oxyder est en silicium.

Une couche de collage peut par exemple être en Si₃N₄, formée par dépôt d'espèces atomiques de Si₃N₄ ou par nitruration thermique dans le cas où la surface à oxyder est en silicium.

Une couche de collage peut par exemple être en SiOₓN_{y}.

Ainsi, une gravure HF de 8000 Å à 1100 Å d'une couche 14 ou 16 de SiO₂ conduit à une rugosité de surface de l'ordre de 0,625 nanomètres RMS, ce qui donne une énergie de collage avec l'autre couche 16 ou 14 de SiO₂ de l'ordre de 500 mJ/m² au lieu d'environ 2 J/m² habituellement rencontrés pour un collage de deux couches de SiO₂ n'ayant pas subi de rugosification, ce résultat étant tiré de l'article page 183 du recueil intitulé "Proceedings of the 2nd International Conference on Materials for Microelectronics" (IOM communication, 1998) de Olivier Rayssac et Coll.

Après rugosification de la surface du substrat démontable, le collage du premier substrat 41 avec le deuxième substrat 42 est mis en oeuvre.

Le collage peut être hydrophile (éventuellement aidé par la mise en oeuvre d'une étape préalable de rinçage).

Une quatrième technique de fragilisation peut consister en la formation d'une couche de collage 14 ou 16 au niveau d'au moins une des deux surfaces à coller, comme par exemple des colles dont le caractère durcissable voireréversible peut être contrôlé thermiquement et/ou optiquement.

Le collage est avantageusement suivi d'un traitement thermique et/ou optique adapté pour renforcer plus ou moins les liaisons de collage, et ainsi atteindre une énergie de liaison ayant une faible valeur déterminée

En référence aux figures 5b ou aux figures 5c à 5d, a lieu après collage une réduction du deuxième substrat 42.

En référence à la figure 5b, la réduction du deuxième substrat 42, afin de n'en conserver qu'une couche 18, peut être réalisée par élimination progressive de celui-ci par polissage et/ou gravure chimique par la face arrière (plus connue pour l'homme du métier sous le nom de procédé technique "etch-back").

Optionnellement, une couche d'arrêt à la gravure est préalablement prévue dans le deuxième substrat 42, au niveau ou au voisinage de la partie 18 du deuxième substrat 42 à conserver, et l'enlèvement de matière se terminant donc par une gravure sélective.

De façon alternative, en référence aux figures 5c et 5d, la réduction du deuxième substrat 42 est réalisée au niveau d'une zone préalablement fragilisée 45 en apportant de l'énergie thermique et/ou mécanique ; cette zone de fragilisation 45 est avantageusement réalisée par implantation contrôlée d'espèces atomiques à son niveau (on parle alors de techniques Smart-Cut) ou par porosification d'une couche à son niveau (ces techniques ayant déjà été décrites plus haut en référence à la figure 4).

Préférentiellement, une étape de finition est mise en oeuvre, utilisant des techniques telles qu'un polissage, une abrasion, une gravure chimique, une planarisation mécano-chimique (encore appelée CMP), un recuit RTA, un bombardement d'espèces atomiques, une oxydation sacrificielle ou autre.

Dans tous les cas, le substrat donneur 10 comprend, après la mise en oeuvre d'une technique de fragilisation, une zone fragile 15.

Après la formation de la couche fragile 15 dans le substrat donneur 10, est mise en oeuvre ladite étape (b) de formation de motif en relief à la surface d'un substrat dit récepteur 20, qui est destiné à être collé au substrat donneur 10.

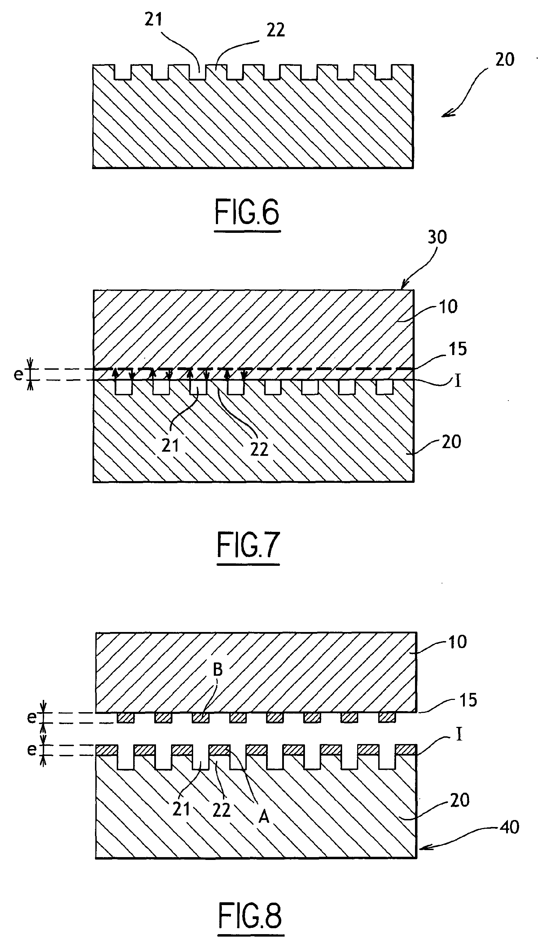

En référence à la figure 6, un ou plusieurs motifs en relief sont réalisés en surface du substrat récepteur 20.

Dans un premier cas, ces motifs sont formés par dépôt d'espèces atomiques cristallinessur le substrat récepteur 20, après la formation d'une couche de masquage sur sa surface, bloquant le dépôt ou l'épitaxie sur les zones hors motif. On pourra par exemple employer de l'oxyde de silicium pour former cette couche de masquage (bloquant notamment l'épitaxie de matériaux III-V). La formation des motifs dans la couche de masquage peut être obtenue par des techniques de photolitographie. La méthode de dépôt est préférentiellement une croissance cristalline, telle qu'une épitaxie par CVD ou MBE.

Dans un deuxième cas, les motifs sont formés par gravure dans l'épaisseur de la surface du substrat récepteur 20 après y avoir appliqué un masque, le masque ayant la même topographie que celle du jeu de motifs que l'on souhaite obtenir. Les gravures employées sont avantageusement des gravures chimiques, par voie sèche ou humide réalisées sur le substrat donneur 10 et sont associées à des étapes de photolithographie.

Dans les deux cas, la formation des motifs est mise avantageusement en oeuvre de sorte à conserver entre les motifs et la zone fragile 15 une couche de matériau ayant une épaisseur moyenne « e » suffisamment faible pour avoir un effet raidisseur sensiblement supérieur aux forces de liaison de la zone fragile 15 du susbtrat donneur 10.

En référence à la figure 6, est représentée une pluralité de motifs représentés ici en vue en coupe.

Un motif 22 en relief est adjacent à un creux 21 dans le substrat récepteur 20 de sorte qu'il fasse saillie en surface.

Les motifs représentés sur la figure 6 ont une forme en coupe sensiblement rectangulaire.

De façon avantageuse, un motif 22 a ses faces latérales sensiblement perpendiculaires au plan principal du substrat récepteur 20.

La forme d'un motif 22 peut être cependant quelconque, même si la forme conventionnelle d'une puce (qui aura une forme géométrique calquée sensiblement sur celle du motif) est la plupart du temps parallélépipédique ou cylindrique.

Les motifs peuvent être de forme et de taille différentes les uns par rapport aux autres dans un même substrat récepteur 20, être alignés régulièrement ou de façon moins ordonnée.

La surface libre d'un motif est avantageusement plane pour faciliter le futur collage de l'étape (c) avec le substrat donneur 10 (voir figure 7).

Dans le cas d'une pluralité de motifs présents en surface du substrat récepteur 20, les surfaces libres des motifs sont avantageusement comprises sensiblement dans un même plan afin que le futur collage de l'étape (c) avec le substrat donneur 10 (voir figure 7) soit réalisé de façon uniforme sur tous les motifs.

Optionnellement, une étape de finition des surfaces des motifs est éventuellement mise en oeuvre, utilisant par exemple une des techniques sus évoquées.

Selon ladite étape (c) et en référence à la figure 7, le substrat récepteur 20 est collé au substrat donneur 10 au niveau des surfaces libres des motifs en relief, l'ensemble formant une plaquette 30. Ce collage peut être de type hydrophile.Le collage peut être aidé par une application préalable de couches de collage et au niveau des surfaces à coller, comme par exemple des colles thermodurcissables voire de colles durcissables par application de rayon UV, ou par formation de couches d'oxyde.

Le collage est avantageusement suivi d'un traitement thermique adapté pour renforcer les forces de collage, afin que ces dernières soient sensiblement plus importantes que les forces de liaison de la zone fragile 15.

Plusieurs variantes de techniques de collage sont notamment proposées dans ledit livre "Semiconductor Wafer Bonding Science and Technology".

La plaquette 30 obtenue comprend alors l'ensemble des motifs dans sa partie comprise entre la zone fragile 15 et l'interface de collage I.

Une couche de matériau, d'épaisseur moyenne « e », sépare les motifs de la zone fragile 15.

Ce peut être un différentiel entre des énergies de collage au niveau de l'interface de collage I et des forces de liaison au niveau de la zone fragile 15, ainsi que la valeur de l'épaisseur « e », qui vont principalement déterminer les conditions de détachement souhaité, lors de l'étape (d), au voisinage de la zone fragile 15.

Lesdites techniques de formation de la zone fragile 15 réalisée au cours de l'étape (a), lesdites techniques de formation des motifs au cours de l'étape (b) et lesdites techniques de collage réalisées au cours de l'étape (c), doivent donc être chacune convenablement choisies et paramétrées pour que le détachement de l'étape (d) ait lieu selon l'invention.

Selon l'étape (d) et en référence à la figure 8, un détachement d'une partie du substrat donneur 10 collée au substrat récepteur 20 est mis en oeuvre au voisinage de la zone fragile 15.

Ce détachement est réalisé par apport d'énergie à la plaquette 30.

Avantageusement, l'énergie de liaison au niveau de la zone fragile 15 est sensiblement moins importante que l'énergie de collage au niveau de l'interface I, le détachement se faisant donc dans ce cas plus facilement le long de la zone fragile 15 que le long de l'interface de collage I.

Dans ce dernier cas la valeur de l'énergie apportée au cours de l'étape (d) peut être choisie pour être comprise entre l'énergie de liaison de la zone fragile 15 et l'énergie de collage de l'interface de collage I.

L'énergie peut être apportée de façon sensiblement homogène sur tout le volume de la plaquette 30, telle qu'une énergie thermique. On peut par exemple traiter thermiquement la plaquette 30 de sorte à fragiliser d'avantage les liaisons au niveau de la zone fragile 15 jusqu'à y obtenir un détachement d'une partie du substrat donneur 10.

Cet apport d'énergie peut aussi être mécanique, par application de contrainte de traction et/ou de flexion et/ou de cisaillement.

De façon alternative ou combinée, l'énergie peut aussi être apportée localement.

L'énergie est préférentiellement apportée localement au niveau de la zone fragile 15, afin qu'elle soit transmise à la zone fragile 15 (et aux faibles liaisons que celle-ci contient) plutôt qu'à l'interface de collage I.

On pourra par exemple appliquer une force sur un biseau disposé au niveau de la zone fragile 15 dans une direction sensiblement parallèle au plan de la zone fragile 15, pour amorcer en bord de la plaquette 30 l'ouverture en deux de la plaquette 30 au voisinage de la zone fragile 15.

Dans tous les cas, l'apport d'énergie selon l'invention est effectué de sorte à favoriser un détachement de la plaquette 30 au voisinage de la zone fragile 15.

Le détachement au voisinage de la zone fragile 15 va alors se faire au niveau de l'interface la plus faible environnant la zone fragile 15, le détachement se faisant selon un profil correspondant à un principe de moindre énergie de liaison au voisinage de la zone fragile 15.

Au voisinage de la zone fragile 15, deux types de liaisons faibles existent :
- les liaisons faibles situées au niveau de la zone fragile 15 ;
- les liaisons faibles associées aux parties creuses (qui forment alors des cavités internes à la plaquette 30) séparant les motifs.

Au niveau d'un motif tel que le motif 22 (et donc une partie pleine), la rupture aura ainsi tendance à se faire le long de la zone fragile 15.

En revanche, au niveau d'une partie creuse telle que la partie creuse 21 et donc la cavité interne 21, du fait de la présence de deux desdits types de liaisons fragiles, le détachement aura tendance à se faire :
- le long de la zone fragile 15 ;
   ou
- le long de la cavité interne 22, passant outre l'effet raidisseur de la couche de matériau d'épaisseur « e ».

Ainsi, si l'épaisseur « e » est suffisamment faible (c'est à dire si les motifs sont suffisamment proches de la zone fragile 15), cette épaisseur dépendant de la taille et de la répartition des motifs et des propriétés mécaniques du matériau, l'effet raidisseur de la couche d'épaisseur « e » peut devenir moins importante, lors du détachement, par rapport aux autres forces en jeu (et notamment par rapport aux forces de liaison de la zone fragile 15), et la force mécanique de détachement, dont le profil suivra avantageusement l'énergie de liaison minimum, va alors dévier par rapport au plan de la zone fragile 15, pour suivre une autre direction, à travers la couche d'épaisseur « e ».

Une rupture de la couche d'épaisseur « e » s'opèrera donc localement, ouvrant ainsi la cavité 21.

Puis, une fois la cavité 21 ouverte, et toujours pour des raisons de minimisation d'énergie, une deuxième rupture va être faite à travers la couche d'épaisseur « e », au niveau de la fin de la cavité 21, pour atteindre la zone fragile 15, au niveau de laquelle le détachement va continuer à s'opérer, au niveau du motif 22.

Dans un premier cas, ces ruptures locales au niveau de la couche d'épaisseur « e », réalisées sur toute la superficie de la plaquette 30, se font selon une direction sensiblement transversale à la couche d'épaisseur « e », de sorte à suivre le chemin le plus court de la zone fragile 15 à la cavité 22.

Dans un deuxième cas, ces ruptures sont des clivages se faisant selon des plans cristallographiques à plus faible énergie, par exemple le plan de glissement <111> dans un réseau de silicium.

Dans un troisième cas, les ruptures peuvent être obtenues selon à la fois des plus courts chemins et selon des plans cristallographiques préférés.

En tous les cas, ces ruptures sont franches et laissent des surfaces de rupture particulièrement planes.

Après détachement, une structure 40 est obtenue, comprenant le substrat récepteur 20 sur lequel sont collés les motifs (dont le motif 22), au-dessus desquels se trouvent des entités en matériaux semiconducteurs d'épaisseurs « e » (dont l'entité "A").

Ces entités ont en fait été prélevées de la couche d'épaisseur « e », par rupture dans la couche d'épaisseur « e », laissant leurs « parties négatives » (dont la partie "B") sur la partie inférieure 19 du substrat donneur 10.

Etant donné la nature du prélèvement, par rupture dans l'épaisseur « e », qui trouve son origine dans la recherche de la moindre énergie de liaison lors de l'apport d'énergie externe, sont obtenues des entités ayant des bords francs, bien définis, droits.

Ces bords peuvent avoir une inclinaison par rapport au plan général de la couche d'épaisseur « e » dépendant de la nature de la rupture (selon un plan cristallographique ou selon « un plus court chemin ») ou des formes des motifs formés dans le substrat récepteur 20.

Des formes d'entités plus « exotiques » que des plots droits peuvent en particulier aussi être trouvées, notamment en jouant sur l'inclinaison des facettes latérales des motifs par rapport au plan de la zone fragile 15, ou sur les plans cristallographiques de la couche d'épaisseur « e ».

La Demanderesse a ainsi vérifié qu'il était possible d'obtenir de cette façon des entités de très bonnes qualités et avec desdites caractéristiques géométriques autant voire plus proches de la perfection que celles de l'état de la technique.

D'autre part, le procédé selon l'invention permet de transférer toute ou partie d'une grande quantité d'entités en un seul détachement, et constitue donc un procédé rapide de réalisation d'entités semiconductrices sur substrat.

L'ensemble [motif 22 ; entité A] forme alors un plot 80 destiné à une application électronique, optique ou optoélectronique.

Les plots peuvent ensuite être retravaillés pour donner des puces déterminées.

Des jeux de plots 80 de qualité sur substrat 20 peuvent ainsi être réalisés rapidement et de façon fiable.

Avec la mise en oeuvre d'un tel procédé selon l'invention on peut en outre permettre un très bon alignement de plots 80 sur le substrat 20.

Et les plots 80 étant alignés dès leur conception, certains dispositifs nécessitant un alignement de plots 80, peuvent ainsi voir leurs réalisations simplifiées.

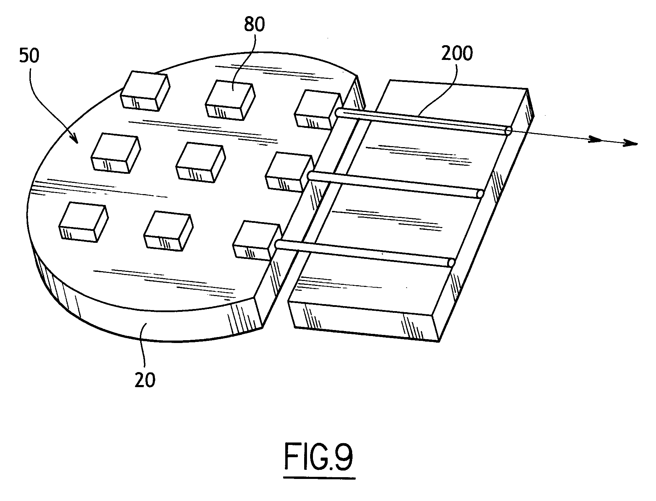

En référence à la figure 9, un exemple d'application du procédé selon l'invention est donné.

Après la mise en oeuvre du procédé selon l'invention, on obtient une matrice 50 de plots 80 en alliage III-V destinée à l'optique ou à l'optoélectronique.

Les plots 80 sont particulièrement bien alignés entre eux et forment donc un réseau en ligne et en colonne.

Il ne suffit plus alors que de relier les plots 80 entre eux pour former un réseau de fibres optiques 200.

Les plots 80 peuvent aussi être individualisés, ou groupés, par des moyens conventionnels, formant respectivement des plots individuels ou des barrettes ou ensembles de plots.

Le plot 80 ou la puce 80 ainsi individualisée singulièrement ou en groupe peut par la suite être soudée sur une embase dissipatrice thermique, reliée électriquement à un contact électrique (par exemple d'amener un fil métallique (Al, Au,...) par thermocompression ou par ultrason), couplée à une fibre optique de façon particulièrement performante (en vue d'un rendement de l'énergie optique d'entrée et/ou de sortie de la puce 80 optimal), placée dans une boite et alignée avec une sortie et/ou une entrée optique de cette dernière, reliée à d'autres puces 80 par des circuits métalliques en relief plus ou moins complexes, etc...

Quelques exemples d'application du procédé selon l'invention pour des matériaux de type III-V sont présentés ci-dessous, et plus particulièrement des exemples de substrat donneur 10 à partir desquels la réalisation des plots (ou puces) est mise en oeuvre.

### Exemple 1 : Le substrat donneur 10 est constitué :

- d'une partie inférieure 19 constituée :
   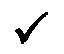 d'un substrat support comprenant de l'AsGa au niveau de son interface avec la couche tampon sus-jacente ;
   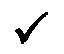 d'une couche tampon métamorphique, et comprenant de l'InGaAs au niveau de son interface avec la couche mince 18 ;
- d'une couche mince 18 comprenant avant prélèvement de l'InP et/ou de l'InₓGa₁₋ₓAsyP_{1-y}, et étant topographiée en motifs.

### Exemple 2 : Le substrat donneur 10 est constitué :

- d'une partie inférieure 19 constituée :
   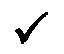 d'un substrat support en saphir ou en SiC ou en Si ;
   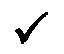 d'une couche tampon métamorphique constituée :
      - d'une couche tampon métamorphique en Alₓ Ga₁₋ₓ N, x variant en épaisseur de 0 à 1 à partir de l'interface avec le saphir ;
      - d'une couche additionnelle en GaN destinée à confiner des défauts cristallographiques de type dislocation ;
- d'une couche mince 18 en nitrure.

Des plots 80 formés selon l'invention et comprenant des entités en un nitrure III-V, tel que GaN, AlN ou InN ont un intérêt dans le domaine de la micro électronique en particulier dans des dispositifs émetteurs de lumière tels que des lasers pour des applications telles que la lecture ou l'écriture de données stockées à haute densité sur disques compacts ou tels que des diodes électro-luminescentes pour des nouvelles technologies d'affichage. Ces matériaux sont aussi tout désignés pour la fabrication de composants électroniques de haute puissance ou encore fonctionnant à haute température.

Un mode de réalisation de la couche mince 18 est une croissance épitaxiale sur la couche additionnelle en GaN par dépôt de métaux organiques du groupe I, tels que le Triméthyl Galium, le Triméthylamine Alane, ou le Triméthyl Indium pour les dépôts respectifs de couches de GaN, AlN et InN.

### Exemple 3 : Le substrat donneur 10 est constitué :

- d'un substrat 1 constitué :
   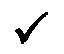 d'un substrat support en saphir ou en SiC ou en Si ;
   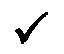 d'une couche intermédiaire en GaN ;
   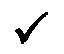 d'un masque en SiO₂ ;
   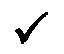 d'une couche tampon en GaN ;
- d'une couche mince 18 en GaN.

Le mode de réalisation de la couche tampon consiste à faire croître de façon anisotropique des couches de nitrures, et en particulier ici de GaN, selon la technique appelée ELOG.

Le masque en SiO₂ utilisé dans cette configuration a avantageusement une forme en bandes disposées sur la couche intermédiaire de GaN, de façon périodique et sensiblement parallèle entre elles.

L'épaisseur de chaque bande est typiquement de l'ordre de quelques dixièmes de microns alors que la largeur d'une bande est de l'ordre de quelques microns.

La période distançant les bandes l'une de l'autre est typiquement autour de 10 microns ou de 15 microns.

On pourra par exemple avoir un réseau de bandes de 13 microns de période, chaque bande ayant 0,2 microns d'épaisseur et 5 microns de largeur.

Ces bandes de SiO₂ vont provoquer dans la ou les couches de GaN sus-déposées latéralement des dislocations localisées au voisinage de la surface libre de ces bandes.

L'épaisseur de GaN dans laquelle ces dislocations sont localisées autour du masque constitue alors ladite couche tampon.

La couche mince 18 en GaN est formée par dépôt vertical sur la couche tampon.

Pour plus de précisions quant au mode de réalisation d'une plaquette selon le procédé ELOG, on pourra se référer au document tiré du « MRS Bulletin » de mai 1998, volume 23, n°5, à l'Article de Shuji Nakamura intitulé «In/GaN/AlGaN- Based Laser Diodes with an Estimated Lifetime of Longer than 10,000 Hours ».

La présente invention ne se limite bien sûr pas à l'utilisation des précédents matériaux, mais s'appliquent aussi à tous matériaux cristallins à partir desquels peuvent être mis en oeuvre des procédés selon l'invention.

Le réseau de motifs peut comprendre un ou plusieurs motifs, être ordonné ou désordonné, constituer de motifs ayant des formes identiques ou différentes, du moment que un procédé selon l'invention peut être mis en oeuvre, permettant de détacher une entité du substrat récepteur, notamment en contrôlant des différentiels d'énergie entre des énergies du collage et des énergies de liaisons fragiles.

## Revendications

1. Procédé de réalisation d'une entité en matériau choisi parmi les matériaux semiconducteurs, sur un substrat récepteur, **caractérisé en ce qu'**il est mis en oeuvre à partir d'un substrat donneur et du substrat récepteur, le substrat récepteur comprenant en surface un ou plusieurs motifs en relief, le substrat donneur étant collé au substrat récepteur au niveau de ce ou ces motifs, une zone fragile étant présente dans le substrat donneur à une profondeur déterminée de sorte à définir une couche mince entre la zone fragile et l'interface de collage, et **en ce que** le procédé comprend un apport d'énergie de sorte à :
- conserver le collage entre le motif et le substrat donneur ;
- détacher du substrat donneur une partie de la couche mince située au niveau de chaque motif, en rompant des liaisons dans la zone fragile et dans l'épaisseur de la couche mince, cette partie détachée formant l'entité.

2. Procédé selon la revendication précédente, **caractérisé en ce que** la rupture dans l'épaisseur de la couche mince est un clivage selon un ou des plans de glissement.

3. Procédé selon la revendication précédente, **caractérisé en ce que** l'apport d'énergie comprend un apport d'énergie localisé.

4. Procédé selon la revendication 1 ou 2, **caractérisé en ce que** l'apport d'énergie comprend un apport d'énergie localisé au niveau de la zone fragile.

5. Procédé selon la revendication précédente, **caractérisé en ce que** les forces de liaison au niveau de la zone fragile sont sensiblement moins importantes que les forces de collage entre le motif et le substrat récepteur.

6. Procédé selon la revendication précédente, **caractérisé en ce que** l'apport d'énergie comprend un apport d'énergie sensiblement homogène sur tout le volume de la plaquette constituée du substrat donneur et du substrat récepteur collés ensemble.

7. Procédé selon l'une des revendications précédentes, **caractérisé en ce qu'**il comprend en outre, avant l'apport d'énergie, une étape de fragilisation du substrat donneur de sorte à former la zone fragile.

8. Procédé selon l'une des revendications précédentes, **caractérisé en ce que** l'étape de fragilisation comprend :
- une implantation d'espèces atomiques dans le substrat donneur à une profondeur voisine de la profondeur de la zone fragile ;
- une surfragilisation de la zone implantée pour former la zone fragile.

9. Procédé selon la revendication 7, **caractérisé en ce que** l'étape de fragilisation comprend une porosification d'une plaquette support pour former une couche poreuse en surface de cette plaquette support, suivie d'une croissance cristalline d'une couche supérieure sur la couche poreuse, lesdites plaquette support, couche poreuse et couche supérieure réalisant ledit substrat donneur, la couche poreuse réalisant ladite zone fragile.

10. Procédé selon la revendication 7, **caractérisé en ce que** l'étape de fragilisation comprend un collage de deux plaquettes dont au moins une a sa surface de collage ayant été préalablement rugosifiée, suivie d'une réduction d'une des deux plaquettes collées de sorte à laisser une couche supérieure collée aux rugosités, la plaquette restante et la couche supérieure réalisant ledit substrat donneur, les rugosités réalisant ladite zone fragile.

11. Procédé selon l'une des revendications précédentes, **caractérisé en ce qu'**il comprend en outre, avant l'apport d'énergie, la formation d'une topographie du ou des motifs en surface du substrat récepteur .

12. Procédé selon l'une des revendications précédentes, **caractérisé en ce qu'**il comprend en outre, après l'apport d'énergie, une individualisation d'une ou de plusieurs entités en surface du substrat récepteur.

13. Procédé selon l'une des revendications précédentes, **caractérisé en ce qu'**il comprend en outre, après l'apport d'énergie, une liaison optique entre des entités.

14. Procédé selon l'une des revendications précédentes, **caractérisé en ce qu'**au moins une entité réalisée est en alliage III-V.

15. Procédé selon l'une des revendications précédentes, **caractérisé en ce qu'**au moins un motif est en alliage III-V.

16. Plaquette obtenue au cours de la mise en oeuvre d'un procédé selon l'une des revendications précédentes, **caractérisée en ce qu'**elle est constituée de deux substrats collés ensemble, un des deux substrats comprenant :
- en surface des motifs saillants collés à l'autre substrat ; et
- une zone mécaniquement fragile située sous les motifs saillants.

17. Application du procédé selon l'une des revendications 1 à 15, à la fabrication de puces sur substrat pour l'électronique, l'optique ou l'optoélectronique, une puce étant constituée d'un motif et de l'entité détachée sus-jacente, le substrat étant le substrat récepteur.

18. Application selon la revendication précédente plus précisément à la fabrication de puces pour lasers semiconducteurs, tels que des émetteurs LEDs ou des LDs ou des récepteurs optiques.
